# EUROPEAN PATENT SPECIFICATION

(11) **EP 2 590 756 B1**
(45) Date of publication and mention of the grant of the patent: **04.11.2020**
(21) Application number: 11804347.0
(22) Date of filing: 07.07.2011
(51) Int. Cl.: C23C 16/00, C23C 14/22, C23C 14/32, H01J 37/32

(54) **METHOD AND APPARATUS FOR APPLYING A COATING AT A HIGH RATE ONTO NON-LINE-OF-SIGHT REGIONS OF A SUBSTRATE**
VERFAHREN UND VORRICHTUNG ZUM AUFBRINGEN EINER GROSSEN MENGE EINER BESCHICHTUNG AUF NICHT SICHTBAREN BEREICHEN EINES SUBSTRATS
PROCÉDÉ ET APPAREIL POUR APPLIQUER UN REVÊTEMENT À GRANDE VITESSE SUR LES RÉGIONS HORS DE VUE D'UN SUBSTRAT

(30) Priority: 07.07.2010 US 339126 P
(43) Date of publication of application: 15.05.2013
(73) Proprietor: Directed Vapor Technologies International, Inc., Charlottesville, VA 22903 (US)
(72) Inventor: HASS, Derek, Charlottesville VA 22903 (US); GOGIA, Balvinder, Charlottesville VA 22911 (US)
(74) Representative: von Hellfeld, Axel
(86) International application number: PCT/US2011/043205
(87) International publication number: WO 2012/006433

(56) References cited:
- WO-A1-2005/085743
- US-A- 5 571 332
- US-A1- 2005 106 435
- US-A1- 2005 255 242
- US-A1- 2008 220 177
- US-A1- 2008 220 177
- US-A1- 2009 017 217
- US-B2- 7 122 085

## Description

### RELATED APPLICATIONS

The present application relates to and claims priority to Provisional Patent Application Serial No. 61/339,126 entitled "Method for applying a coating at a high rate onto non-line-of-sight regions of a substrate" filed July 7, 2010.

### FIELD OF THE INVENTION

The present invention relates generally to the field of directed vapor deposition and more specifically to the deposition of materials onto non-line of sight areas.

### BACKGROUND

Substrates can be coated by reactive or non-reactive evaporation using conventional processes and apparatuses known as physical vapor deposition (PVD).

An improved process and apparatus for vapor depositions on a substrate in a vacuum has been developed and is known as directed vapor deposition (DVD).

The present invention improves the DVD process by the development and incorporation of advanced methods and apparatus, which enable materials to be effectively applied at high rate with the desired composition and microstructure onto complex components having non line-of-sight (NLOS) regions.
WO 2005/085743 A1 describes the internal coating by means of a PVD method of workpieces with deep drillings and barrels of firearms, whereby the plasma mist is directed with a particular nozzle and protective gas such as tob e incident on the inner wall of the drilling and form a layer there which is low-friction, hard, temperature-resistant and wear-resistant.
US 2009/0017217 A1 describes a method for applying a coating on a substrate comprising pa chamber having a specific down stream pressure, an evaporant source, a primary carrier gas stream, impinging the evaporant source with an energetic beam to generate an evaporated vapor flux comprised of evaporant molecules, the primary carrier gas stream deflecting at least a portion of at least one of said generated evaporated vapor flux by the primary carrier gas stream into the interior cavity of the substrate.
US 2005/0106435 A1 describes a twin-wire arc deposition method for depositing a nano-structured catalyst coating onto a solid electrolyte membrane or an electrode substrate from a precursor catalyst material selected from the group consisting of a metal, metal alloy, metal compound, and ceramic material.
US 5,571,332 B1 describes a gas jet film deposition system including a source of thermionoically emitted electrons which are accelerated through carrier gas and generate He ions by impact ionization.
US 2008/0220177 A1 describes a method and apparatus for forming a thermal barrier coating system in communication with at least a portion of a substrate, including depositing a first bond coat on a portion of the substrate, depositing first thermal barrier coat on the bond coat, whereby the deposition occurs one or more chamber to form the thermal barrier coating system, and wherein the deposition of the first bond coat and the deposition of the first thermal barrier coat is performed without out-of-chamber handling of the thermal barrier coating system.

### BRIEF DESCRIPTION OF THE INVENTION

The present invention is defined by the appended claims and provides for a method and apparatus for the directed vapor deposition (DVD) of materials onto non-line of sight (NLOS) portions of a substrate. The method and apparatus includes evaporating a first material for deposition onto the substrate, the evaporation generating a plurality of vapor molecules. The method and apparatus therein provides for the insertion of a carrier gas and the direction of the vapor molecules to be deposited in NLOS regions of the substrate. The present invention provides for varying embodiments incorporating different aspects for improving the NLOS DVD usable individually or in combination.

The present invention includes varying embodiments for the NLOS DVD including in one embodiment utilizing plasma activation to ionize the vapor particles to create charged vapor molecules. This embodiment further includes biasing the substrate to attract the charged vapor molecules onto the NLOS portion of the substrate. In one embodiment, the plasma activation may include a hollow-cathode plasma unit.

The present invention includes another embodiment for the NLOS DVD including utilization of an inert gas as the carrier gas. The inert gas as a carrier gas provides for a specific density and velocity, so the energy of the carrier gas enhances the NLOS affect. For example, the inert gas may be Helium or Argon, such that the insertion of the inert gas as the carrier gas provides for the deposition of the vapor molecules in the NLOS region.

The present invention includes another embodiment for NLOS DVD including pre-heating the carrier gas prior to its insertion into the deposition chamber. Varying embodiments may be utilized to heat the carrier gas prior to its insertion into the chamber, such that upon insertion therein, the carrier gas provides for improved NLOS DVD on the substrate.

The present invention includes another embodiment in which the carrier gas nozzle is modified to enable the formation of gas conditions in which enhanced NLOS DVD coating is obtained. The modified nozzle enables the co-evaporation from multiple crucibles which allow for the area coated to be increased.

### BRIEF DESCRIPTION OF THE DRAWINGS

The invention is illustrated in the figures of the accompanying drawings which are meant to be exemplary and not limiting, in which like references are intended to refer to like or corresponding parts, and in which:
Fig. 1 is a schematic illustration showing the effect of substrate biasing on the deposition of charged vapor species onto NLOS regions of substrates;
Fig. 2 is a schematic diagram showing the locations and nomenclature of the different coupons included in the mock-up box substrates, including A: Line of Sight, C: Non Line of Sight;
Fig 3 is an illustration of one embodiment of a hollow cathode plasma activation system for use with a LS-DVD coater;
Fig. 4 is an image showing the use of an Argon carrier gas with one embodiment of a plasma-activated directed vapor deposition technique;
Figs. 5a-d are images of vapor deposition on a stainless steel tube;
Fig. 6 illustrates a plot showing the A to C coating weight ratio for various DVD processing conditions;
Fig 7 illustrates a summary of the improvements obtained by altering the process conditions during mock-up box depositions;
Fig 8a illustrates one embodiment of a gas pre-heater and Fig. 8b illustrates one embodiment of Argon gas temperatures as a function of tube heating time;
Fig 9a illustrates one embodiment of resistive tubing configuration and Fig. 9b illustrates one embodiment of a system encompassing the resistive tubing configuration;
Fig. 10a illustrates one embodiment of a gas heating module and Fig. 10b illustrates one embodiment of the location of the gas heating module relative to the directed vapor deposition device;
Fig. 11 illustrates one embodiment of a gas heater insert;
Fig. 12 illustrates another view of one embodiment of the assembled gas heater;
Fig. 13 illustrates another embodiment of a gas heater;
Fig 14 illustrates variations of gas temperature and coil temperature for the gas heater of Fig. 13;
Fig. 15 illustrates another embodiment of a gas heater;
Fig. 16 illustrates variation of gas temperature as a function of applied power for the gas heater embodiment of Fig. 15;
Fig. 17 illustrates a temperature data log during the deposition process using a gas heater.
Fig. 18 illustrates measured improvements in coupon weight ratio with change in process conditions;
Fig. 19 illustrates SEM micrographs showing the microstructure in the NLOS region of mock up box run using one embodiment of the gas heater;
Fig. 20 is a graph representing erosion resistance of LOS and NLOS TBC samples at room temperature;
Fig. 21 is a graph representing weight loss of coating for both LOS and NLOS regions for two process conditions;
Fig. 22 are schematic illustrations showing the geometry of a multiple source, linear, converging -diverging crucible / nozzle assembly;
Fig. 23 illustrates a vapor density approach using the assembly of Fig. 22;
Fig. 24 illustrates drawings showing the design of the single crucible C/N apparatus which contains a linear converging - diverging nozzle;
Fig. 25 illustrates drawings showing the design of the multi-crucible C/N apparatus which contains a linear converging - diverging nozzle to be used for large components;
Fig. 26 illustrates drawings showing top views of the design of the single crucible C/N apparatus which contains a linear converging -diverging nozzle with adjustable nozzle plates at varying locations;
Fig. 27 illustrates schematics of a crucible nozzle assembly showing the adjustable spacings;
Fig. 28 illustrates a graph of a variation of pressure ratio as a function of nozzle spacing for improved DVD processing conditions;
Fig. 29 illustrates a graph of variations of pressure ratio as a function of nozzle spacing for prior DVD processing conditions; and
Fig. 30 illustrates measured improvements in coupon weight ratio.

### DETAILED DESCRIPTION OF THE INVENTION

This application describes a process for applying materials at high rate having the desired composition and microstructure onto complex components having NLOS regions. Processing conditions for coating on NLOS substrate regions are described that enable:

Improved coating growth rate in NLOS regions of a component beyond prior DVD techniques.

Combinations of high NLOS growth rates and high deposition rates that will reduce the production costs including use of inert gas, such as but not expressly limited to Argon.

The use of advanced gas jet properties along with a plasma activated DVD process that can ionize vapor molecules to further optimize the NLOS growth rates achieved using the DVD approach.

The use of plasma activated directed vapor deposition (PA-DVD) to expand the range of process conditions which result in higher NLOS growth rates and/or high deposition efficiencies than current baseline NLOS coating conditions.

The modifications of the carrier gas velocity, chamber pressure and pressure ratio to increase the coating growth rate in the NLOS regions with similar coating microstructure and crystallinity as in line-of-sight regions.

The identification of DVD process conditions which result in a both excellent NLOS region growth rates and effective performance characteristics (such as a high thermal barrier coating lifetimes, suitable oxidation resistance in a oxidation protection coating or excellent corrosion resistance or environmental protection in a environmental protection coating).

The pre-heating of carrier gas used to create a supersonic gas jet in a DVD approach, enabling an increased velocity (or kinetic energy) in the jet and promote vapor infiltration into NLOS regions of substrate.

The design of a NLOS coating apparatus in which a carrier gas pre-heating capability is included.

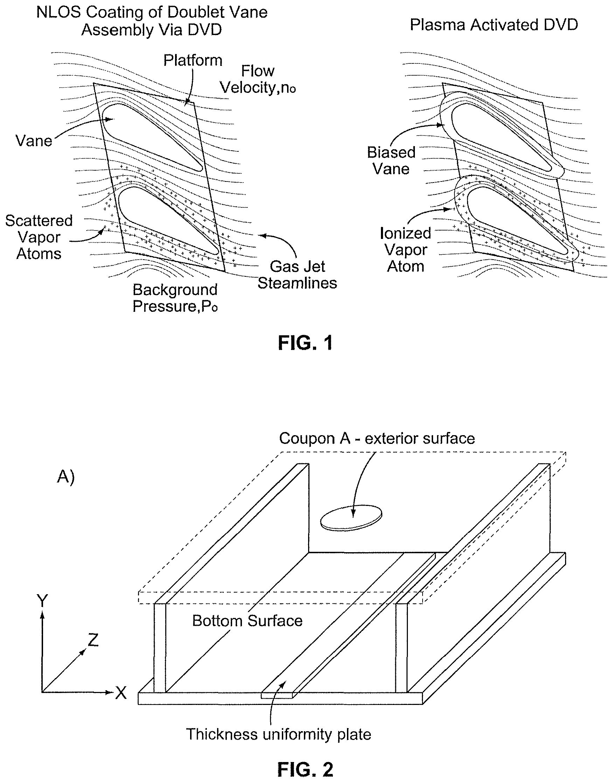

One approach to improve the NLOS coating growth rate is the use of plasma activated directed vapor deposition (PA-DVD). In this case, plasma activation is used to ionize the vapor molecules and pulsed substrate biasing is used to attract the charged molecules onto NLOS surfaces, as illustrated in Figure 1.

NLOS coating in the DVD process is a result of the collisions between carrier gas and vapor molecules that can be used to control the transfer of the vapor molecules from the source to a substrate. These collisions enable the vapor molecules to be swept generally along the streamlines that are established by the carrier gas expansion into the chamber and therefore be transported into internal NLOS regions of substrates/component.

Three steps are utilized to obtain efficient NLOS coating on the interior of a complex engine component (such as a doublet vane). Step 1 is focusing of the vapor flux to create a high density flux of vapor molecules. Step 2 is infiltration of the focused vapor flux into the interior of the component. And Step three is de-focusing of the flux and deposition of the vapor molecules onto the substrate surface.

It has been demonstrated in the past using prior DVD NLOS conditions that the key properties of the gas jet (i.e. its density, velocity) strongly affect the NLOS growth rate and NLOS coating microstructure. This work has demonstrated that additional improvements to the NLOS coating capability of the baseline DVD technique (Version 1.0) may be achieved through the development of novel concepts to enable more optimal processing conditions. Of particular interest are modifications to the gas jet composition, density and velocity. The gas jet properties affect the infiltration of the vapor flux into the interior NLOS regions of complex components. The gas jet velocity can be increased through the incorporation of higher gas jet pressure ratios which can be achieved either through increased chamber pumping efficiency, the use of novel gas jet nozzle designs and/ or the use of carrier gas pre-heating, which are described in further detail below.

Further, novel carrier gas conditions and compositions that modify the momentum of the gas jet atoms can further enhance NLOS coating growth rates. Alternate processing conditions using both He and Ar carrier gases are therefore envisioned. The use of any inert gas such as He, Ne, Ar, Kr and /or Xe and combinations of these are also envisioned as is the use of N₂, Air and O₂ or additions of these into the inert gases. Processing conditions are identified in which improved NLOS growth rates are obtainable using inert gases as the carrier gas (or combinations of the above gases) where the volume fraction and type of the gas are carefully controlled.

The identified processing conditions were studied to determine the rotation rates, temperatures and plasma activation conditions (if any) which enhanced the coating quality. The process conditions explored are given in Table 2.

**Table 2 - Process conditions explored using the PA-DVD process.**

| **Chamber Pressure He (Pa)** | **Pres. Ratio = R3** | **Pres. Ratio = R2** | **Pres. Ratio = R1** | | **Chamber Pressure Ar (Pa)** | **Pres. Ratio = R3** |
|---|---|---|---|---|---|---|
| **8** | A1 | A2 | A3 | | **12** | E1 |
| **16** | B1 | B2 | B3 | | **15** | E2 |
| **24** | C1 | C2 | C3 | | **18** | E3 |
| **32** | D1 | D2 | D3 | | | |

As used in Table 2, A1, A2, B1 and B2 represent the prior art baseline techniques (Version 1.0), whereas A3, B3, C1-C3, D1-D3 and E1-E3 represent varying embodiments of multiple versions of DVD described herein.

The results in Table 3 below indicate significantly improved infiltration of vapor flux and hence the NLOS growth. The coating thickness ratio from coupon A to coupon C and coupon B to coupon C were the lowest of any mock-up box coating condition to date using He carrier gas compositions. It was also observed that reduced gas jet pressure ratios reduced the effectiveness of coating the mock-up boxes (see conditions C2 and B3). This was due to a reduction in the infiltration of the vapor flux into the box.

**Table 3 - DVD Process Conditions and Resulting Coupon Weight Gains for alternative DVD process conditions**

| *A) DVD process conditions for the mock-up box runs using a He carrier gas.* | | | | | | | | | | | | |
|---|---|---|---|---|---|---|---|---|---|---|---|---|
| | **C1** | | **D1** | **C2** | | **B3** | **No-gas** | | | | | |
| **Rotation/rpm** | 3 | | 3 | 3 | | 3 | 3 | | | | | |
| **Δ*t*/min** | 35 | | 25 | 46.5 | | 40 | 42 | | | | | |
| **YSZ (**g**)** | 51.89 | | 31.27 | 48.39 | | 45.11 | 42.32 | | | | | |
| **Ni strip (**g**)** | 0.33 | | 0.0749 | 0.2169 | | 0.0544 | | | | | | |
| **Outside, A** (Δm or g) | 295.4 | | 0.3857 | 0.2118 | | 0.0543 | 0.0597 | | | | | |
| **inside, center, C** (Δm or g) | 109.5 | | 0.0542 | 0.0554 | | 0.0081 | 0.0107 | | | | | |
| **inside, end, B** (Δm or g) | 82 | | 0.1036 | 0.0824 | | 0.0229 | 0.0185 | | | | | |
| | | | | | | | | | | | | |
| PWC/mbar | **0.24** | | 0.32 | 0.24 | | 0.16 | 3.8E-4 | | | | | |
| PGFS/mbar | NA | | 1.8 | 1.4 | | 0.55 | ---- | | | | | |
| PGFS / PWC | NA | | 5.6 | 5.8 | | 3.1 | ---- | | | | | |
| *T*ₘₐₓ/*°*C | ∼900 | | ∼900 | ∼900 | | ∼900 | ∼900 | | | | | |

| *B) DVD process conditions for the mock-up box runs using an Ar carrier gas.* | | | | | | | | | | | | |
|---|---|---|---|---|---|---|---|---|---|---|---|---|
| | **E1** | | **E2** | **E3** | | **E2-M** | **B1-M** | | | | | |
| **Rotation/rpm** | 3 | | 3 | 3 | | 3/0.5 (120 /60) | 3/0.5 (120 /60) | | | | | |
| **Δ*t*/min** | 45 | | 47 | 43 | | 45 | 54 | | | | | |
| **YSZ (**g**)** | 53.4577 | | 48.3648 | --- | | 49.62 | 46.5671 | | | | | |
| **Ni strip (**g**)** | 0.1194 | | 0.2270 | 0.1332 | | 0.2286 | 0.3167 | | | | | |
| **Outside, A** (Δm) | 0.2095 | | 0.1527 | 0.2942 | | **0.1953** | 0.1743 | | | | | |
| **inside, center, C** (Δm) | 0.0545 | | 0.0618 | 0.0916 | | **0.1504** | 0.0688 | | | | | |
| **inside, end, B** (Δm) | 0.0994 | | 0.0819 | 0.1287 | | **0.2164** | 0.1597 | | | | | |
| PWC/mbar | 0.09 | | 0.15 | 0.18 | | 0.15 | 0.17 | | | | | |
| PGFS/mbar | 0.88 | | 1.5 | 1.6 | | 1.5 | 1.3 | | | | | |
| PGFS / PWC | 9.7 | | 10 | 8.89 | | 10 | 7.7 | | | | | |
| *T*ₘₐₓ/°C | ∼900 | | ∼900 | ∼900 | | ∼900 | 1023 | | | | | |

| **C) Comparison of the A to C, B to C and A to B coating thickness ratios for the conditions explored during this work (note: the lower the ratio the higher the NLOS growth rate)** | | | | | | | | | | | | |
|---|---|---|---|---|---|---|---|---|---|---|---|---|
| **Thickness Ratio** | **No Gas** | **A1** | **B1** | **C1** | **D1** | **C2** | **B3** | **E1** | **E2** | **E3** | **E3-M** | **B1** - **M** |
| A to C | 5.6 | 5.0 | 3.8 | 2.73 | 7.12 | 3.82 | 6.7 | 3.84 | **2.47** | 3.21 | **1.29** | 2.53 |
| B to C | 1.7 | 1.8 | 1.4 | 0.75 | 1.91 | 1.49 | 2.8 | 1.82 | **1.32** | 1.41 | **1.38** | 2.32 |
| A to B | 3.2 | 2.7 | 2.7 | 3.6 | 6.87 | 2.57 | 2.4 | 2.11 | **1.86** | 2.29 | **0.90** | 1.09 |

As with Table 3 (C), B1 relates to baseline NLOS processing conditions and E2, E3 and E3-M illustrates results on improved DVD NLOS processing conditions.

These results indicate that higher gas jet pressure ratios should provide a further opportunity to improve the NLOS coating conditions. Such conditions can be obtained using the PS-DVD system following a modification to the nozzle / crucible apparatus used in this system. Heating of the carrier gas may also produce enhanced effects without the need to alter the pumping rate or gas jet nozzle geometry. It is well known that high gas jet velocities can be enhanced by pre-heating the gas jets because the gas jet velocity, U, is proportional to its temperature, T. The gas jet velocity is given by the expression U = M(γRT)^{1/2} where M is the Mach number, γ is the ratio of specific heats, R is the specific gas constant and T is the temperature. Thus, increasing the gas jet temperature prior to expansion in the gas jet nozzle will increase the gas jet velocity.

Mock-up box coating was also performed in the work using an Argon carrier gas flow. It is understood that the higher mass of the Ar carrier gas allows focusing of the vapor flux and improved infiltration into NLOS regions of substrates using reduced gas flows and lower velocities. The use of reduced gas jet velocities while still enabling vapor flux infiltration into the NLOS regions results in more effective NLOS coatings having enhanced NLOS growth rates and properties in part based on the enhancement effects of the inert gas to facilitate vapor deposition. The mock-up box coating data for conditions E1, E2 and E3 are given in Table 3(b). Conditions E2 and E3 gave greatly improved coating uniformity with E2 yielding significantly improved NLOS coating conditions over those obtainable using the baseline approach.

The use of the E2 condition and a variable rotation pattern resulted in greatly enhanced coating uniformity of the mock-up box and indicates very promising processing conditions for use in component coating.

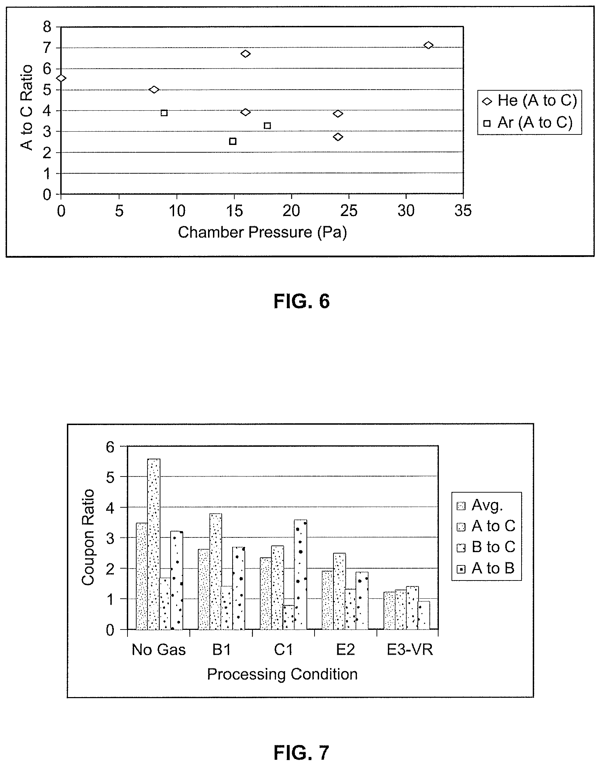

The results from the carrier gas modification work are summarized in Figures 6 and 7. Note that this work has indicated that enhanced NLOS conditions can be obtained using a higher He carrier gas flow (C1 condition) and more optimally moderate Ar carrier gas flows (E2, E3 conditions). Analysis of the mock-up box coating uniformity using these alternative conditions indicate a 1.5X improvement in the NLOS coating ability of the DVD approach. With the further incorporation of a variable rotation pattern near optimal coupon ratios in the mock-up box could be obtained. When compared with a no gas flow condition (similar to that of EB-PVD), the enhanced DVD processing conditions represent a 5X improvement in NLOS coating growth rate on the C coupon.

A 12X improvement is achieved through the combination of the enhanced conditions and variable rotation rate techniques.

The invention further provides for the enhanced NLOS deposition conditions based on the DVD approach using a gas injection apparatus. Multiple embodiments are described in detail below.

The design of a first embodiment of a gas pre-heater is based on a resistively heated tube through which the carrier gas could be flowed. The design was aided by an experimental investigation of heating Ar gas flowing through a tube, such as an Inconel tube. As described herein, the embodiments refer to an Inconel tube, but it is recognized that suitable tube may be utilized and the invention is not expressly limited to an Inconel tube.

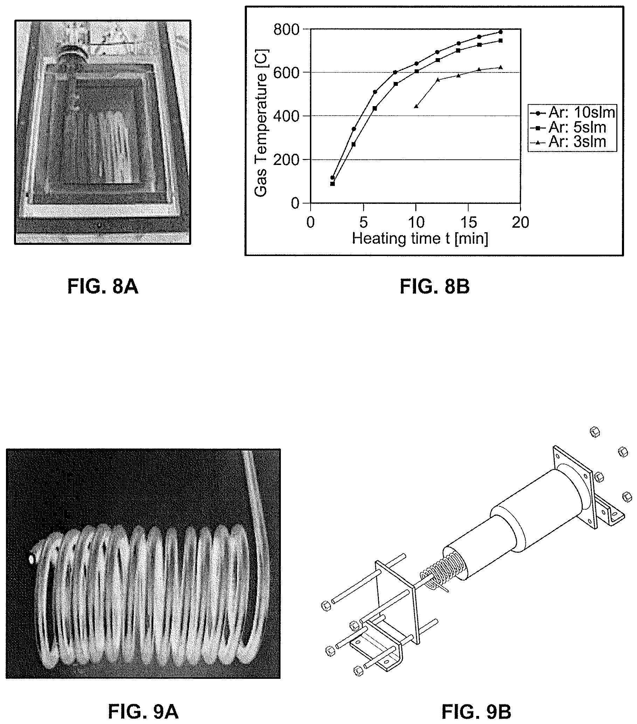

Gas Heater version 1: In this case, the Inconel tubing was wound as a coil and voltage applied directly to each end of the tube so that tubing itself became the resistive heater (Figure 8A). The tubing was electrically insulated from the rest of the gas system by a section of ceramic tubing. The electrical connections were made with clamps around the tubing. The flow rate of Ar gas through the resistively heated tubing was varied. The outlet temperature was measured using a type K thermocouple. The Ar gas flow rate varied from 3 to 10 standard liters per minute (slm) and gas temperature was varied as a function of time (Figure 8 B).

### Gas Heater version 2:

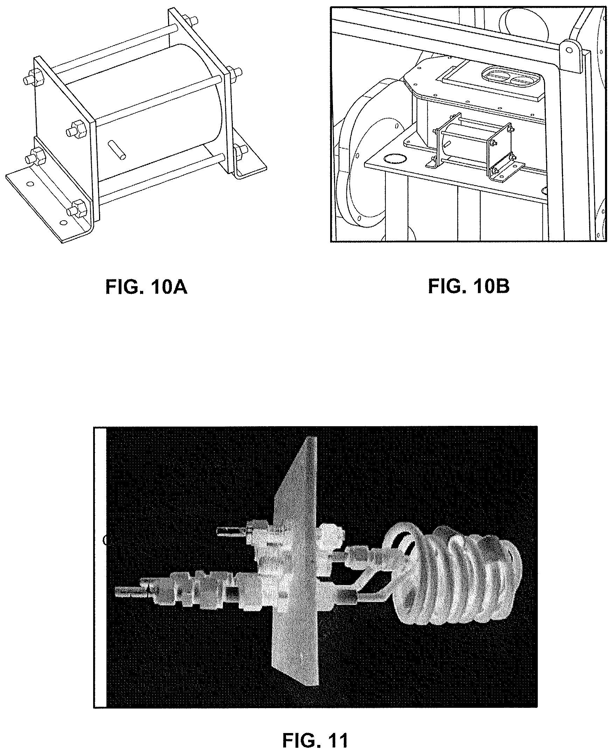

Figs. 9a and 9b show the gas heating tube configuration. The full design of the gas heating module (GHM) and its location in the PS-DVD coater is shown in Figure 10, including 10a illustrating one embodiment of an enclosed system and Fig. 10b illustrating the enclosed system relative to a DVD system.

Following the initial proof of concept of the heater design, the gas heater was designed and constructed next for the PS-DVD coater having varying wall thickness and/or length of the resistively heat gas carrier tube. In the PS-DVD design, (a) the heater was enclosed in a sealed and insulated container to reduce heat loss to the surroundings and (b) the gas exiting the heated coil flowed over the outer coil walls first before exiting the container. The electrical connections were welded to the coil and a thermocouple was added to monitor coil surface temperature for this iteration.

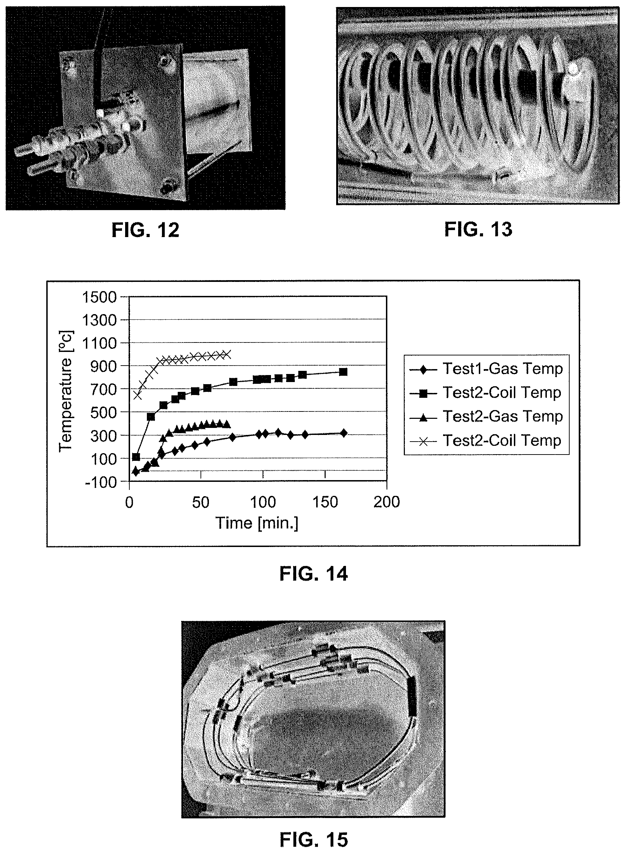

Figures 11 and 12 show the heater coil insert (with electrical and gas connections), fully assembled gas heater and the heater installed in the chamber (outside the nozzle), respectively. Without the gas heater, the carrier gas (helium or argon) and reactive gas (oxygen) mix outside the chamber. With the gas heater present the two gases are separated so that the oxygen does not degrade (oxidize) the Inconel tubing. Initial testing of the PS-DVD gas heater was performed by installing the heater outside the DVD crucible /nozzle (CN) apparatus.

Table 4 shows the results from the tests performed with the PS-DVD gas heater (version 1 and 2) using a range of gas flow conditions and various heater configurations. Note that the carrier gas temperature was observed to be a function of the power applied to the gas heater and the heater configuration.

**Table 4 - Gas Heater Tests**

| **Run** | **Power (W)** | **Heater Configuration** | **Gas Temp(°C)** |
|---|---|---|---|
| A | 2016 | v. 1 | 538 |
| B | 2044 | v. 1 | 570 |
| C | 3250 | v. 2 | 455 |

Gas Heater version 3: To reach gas pre-heat temperatures up to ∼800° C, additional embodiments provide for further optimization of the gas heater design. In this embodiment, the wall thickness, length of the resistively heated gas carrier tube, or both, were altered to improve the reliability and to obtain the high gas temperature. The gas heater v3 consists of single coil, enclosed in a sealed and insulated container to reduce heat loss to the surroundings. The electrical connections in this case were welded to the coil and a thermocouple was added to monitor coil surface temperatures. Figure 13 shows the v3 heater coil insert. This assembly was installed in the PS-DVD chamber outside of the nozzle / crucible apparatus.

To test the v3 heater configuration and determine stable operating conditions, two sets of experiments were designed based on the theoretical calculations concerning the capacity of this heater in terms of applied load and the possible achievable temperature:

Gas flow was kept constant at 20slm and the working chamber pressure was maintained at 10Pa. The power was increased slowly and kept constant at 480 W. The gas temperature and the heater coil temperatures were measured as a function of time. Figure 14 shows the variation of gas temperature and coil temperature. The gas temperature could be stabilized at ∼315°C.

Gas flow was kept constant at 20slm and the working chamber pressure was maintained at 10Pa. The power was increased slowly to 920W and the variation of gas temperature and coil temperature was monitored. Figure 14 shows the variation of gas temperature and coil temperature. The gas temperature could be stabilized at ∼400°C.

Based on the above experimental data, it was concluded that with the above-noted embodiments readily provided for controllably pre-heating the gas temperature in the range of 300-400°C.

Gas Heater version 4: further embodiments of the pre-heating device provide for reaching higher temperatures. One approach included increasing the gas per-heat temperature by incorporating the longer heating tube and installing the heater inside the nozzle / crucible apparatus inside the PS-DVD coater. Figure 15 shows digital images of gas heater v4.

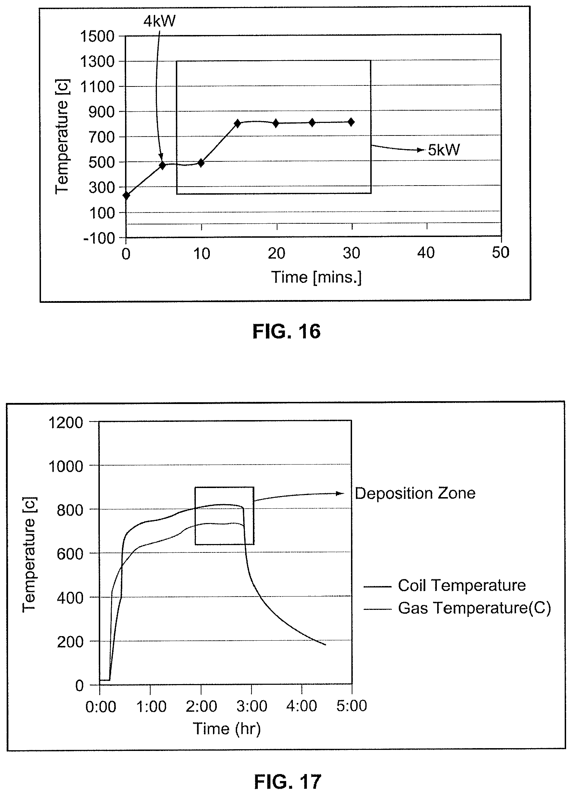

To test the v4 gas heater the same protocol was followed as in previous case (20 slm of gas at 10Pa). Because of the long length of tube, it was possible to apply a higher power (up to 5kW) and the gas temperature and the heater coil temperature were measured as a function of time. Figure 16 shows the variation of gas temperature as a function of time. The maximum stable temperature which could be achieved with this heater was ∼800°C. Thus, this design met the goal for the envisioned temperature requirement for improved NLOS coatings.

Efforts were also made to further improve the process robustness by adding additional thermocouples into the gas pre-heater set-up for continuous monitoring of the gas heater temperatures. Using Labview software a data log was configured in which the temperature was recorded every 10 seconds of both the gas temperature and heating coil temperature to enable the temperature stability during deposition to be monitored as shown in Figure 17. Following this, several deposition runs were performed and a good reproducibility was achieved.

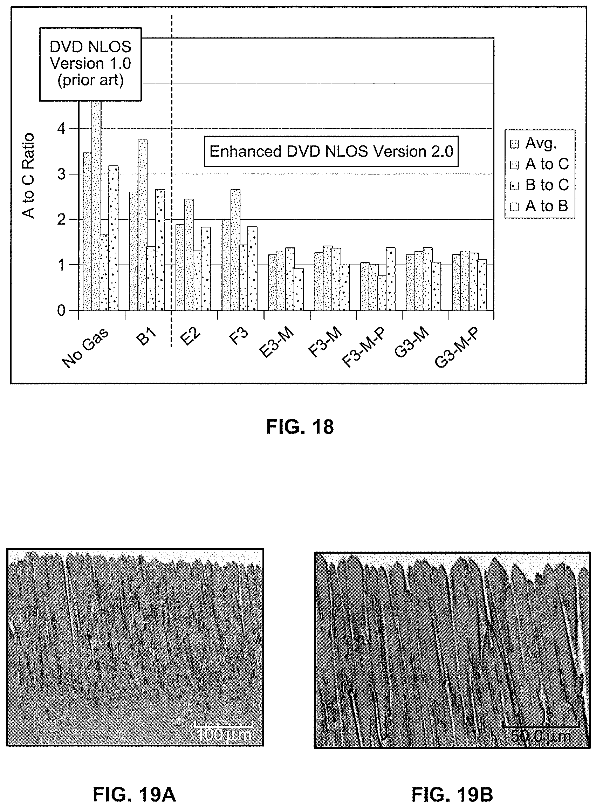

Coatings were deposited using DVD NLOS conditions with or without gas preheating onto test coupons placed in LOS and NLOS regions of a mock-up geometry/box. Table 6 summarizes several of these runs. The change in weight ratio of the coated coupon was measured as a function of process conditions. At the highest gas pre heat temperature, a significant reduction in the thickness ratio of LOS to NLOS regions (A to C) was observed when compared with a no gas pre-heat condition. This clearly demonstrates the fact that with the increase in the carrier gas pre-heat temperature, vapor flux penetrates deeper into NLOS regions thereby resulting in an increase in thickness of coating in those regions. Figure 18 summarizes the coupon ratio for all regions along with improvements obtained by the change in process conditions.

**Table 5 - Summary of DVD NLOS conditions**

| **Gas/Chamber Pressure** | **Gas Preheatin g** | **Process Condition** | **Pressu re Ratio** |
|---|---|---|---|
| Ar/12Pa | no | F3 | 7.8 |
| Ar/12Pa | no | F3-M | 7.8 |
| Ar/12Pa | yes | F3-M-P | 10 |
| Ar/12Pa | x | F3-M-P | 13.6 |
| Ar/12Pa | Yes | G3-M-P | 14.6 |

| | | | |
|---|---|---|---|
| M- Variable rotation :: P - Gas Heating | | | |

In another embodiment, nozzle design variations further provide for improved direct vapor deposition in NLOS regions. Novel converging-diverging nozzle design was explored further to improve the NLOS efficiency and to aid in the development of fully scaled crucible / nozzle appartatus for use during full production scale coating application.

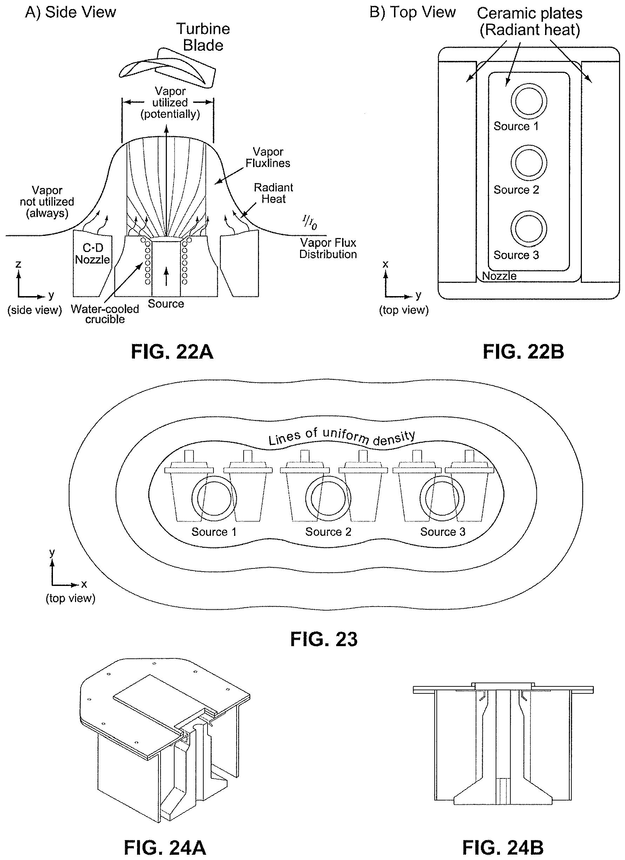

The main concept, shown in Figure 22, is that a linear nozzle exists around multiple crucibles. This enables the coating zone to be enlarged to allow for the application of NLOS coatings onto larger components and/or multiple components during a single run, Figure 23. In this case, the sources are allowed to intermix in one direction while still being focused in a second to create a rectangular / ellipsoidal vapor flux which can infiltrate into the NLOS regions of components. The geometry of the nozzle is a converging-diverging arrangement having a relatively small nozzle opening area (compared with circular design) and thus the potential for higher pressure ratios and the ability to maintain the processing conditions required for good NLOS coating while also enabling larger coating areas.

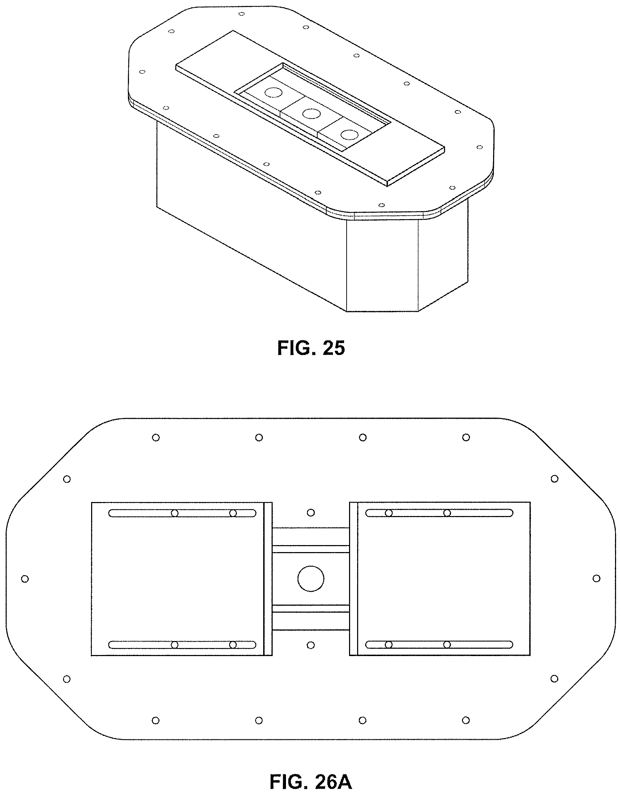

Figure 24 shows the solid works drawing of linear shaped, single source, converging-diverging nozzle. A carrier gas is flowed through the nozzle optionally having a temperature greater than room temperature when using gas pre-heating. The converging-diverging nozzle is created by first creating a crucible to hold the evaporation sources and then adding a nozzle cover plate. The shape of the crucible and nozzle form a converging-diverging nozzle around an array of evaporation sources. The result is a rectangular shaped vapor flux having uniform density in the x-direction and a controllable width (y-direction) such that large components and multiple components can the effectively coated in a uniform fashion. The nozzle width is designed to be adjustable to enable an additional means to control the vapor flux geometry. Figure 25 shows a Solid Works drawing of a multi-crucible-converging-diverging C/N system which can be used to coat large components on production scale.

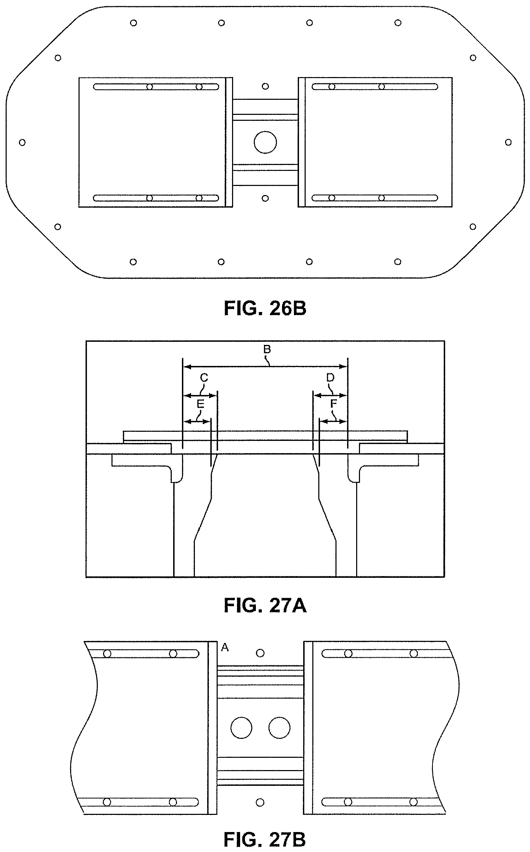

Another design of the single source linear nozzle is given in Figure 26. The design has adjustable side nozzle plates having slots which allowed the nozzle to be adjusted along the Y direction closer to the crucible. This enables the pressure ratio to be altered to promote NLOS DVD coating. The nozzle top plate has been slotted to allow adjustability in the X- direction enable the set-up to be expanded to allow the evaporation of multiple sources simultaneously.

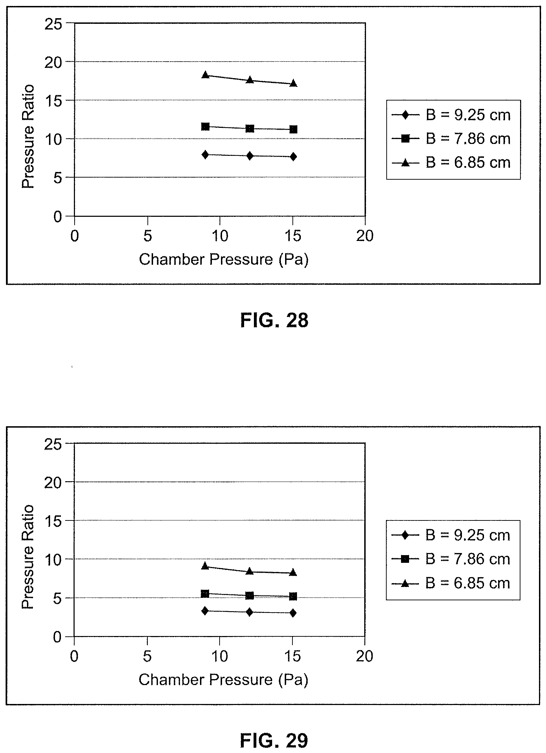

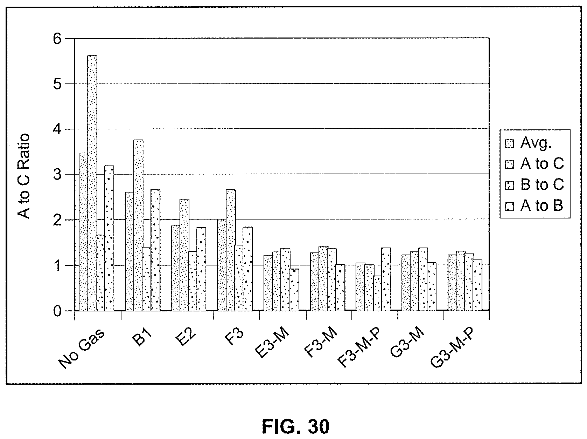

Using the installed single source linear nozzle, several test runs were performed. The nozzle opening area and the area of the diverged section were altered by systematically varying the spacing between nozzle plates and the crucible. Figure 27 shows the geometry of the crucible-nozzle assembly with the key dimensions identified. Table 8 summarizes the range of nozzle width explored. Obtainable pressure ratios for both helium and argon carrier gases were recorded. Pressure ratio tests were performed at room temperature with no evaporation of material and no gas pre heating to collect the baseline data and evaluate the effectiveness of the linear nozzle configuration to control the pressure ratio. Figure 29 and 30 show the variation of pressure ratios for DVD 2.0 (Ar) and DVD 1.0 (He) process conditions as a function of nozzle spacing (or area). As the nozzle spacing decreased, the pressure ratio for both DVD 1.0 and DVD 2.0 conditions both increased respectively.

**Table 8 - Summary of linear nozzle spacing and nozzle opening areas explored.**

| **A (cm)** | **B (cm)** | **Area(cm²)** | **Equivalent circular nozzle dia. (inch)** |
|---|---|---|---|
| 6.99 | 9.25 | 25.2 | 2.23 |
| 6.99 | 7.86 | 15.47 | 1.75 |
| 6.99 | 6.85 | 8.4 | 1.29 |

The processing conditions explored using the above configurations using ambient temperature carrier gas are given in Table 9. Letter and numbers were assigned to each process condition based on the approach used. Using these configurations along with an Argon carrier gas, chamber pressures ranging from 9 to 15 Pa and, in some cases, gas pre heating, optimization of the gas jet conditions required for NLOS coating onto doublet vane mock-up structures were performed The DVD NLOS process conditions are categorized with symbols F, G or H (Table 9) to distinguish runs performed using either the baseline (F), RANC#1(G) or RANC#2 (H) condition. Each nozzle set-up had a distinct range of pressure ratios. The inclusion of the letters M or P in the process condition code represented the sub conditions of rotation and gas pre heat, respectively

**Table 9 - DVD NLOS version 2 process conditions..**

| **Chamber Pressure Ar (Pa)** | **Baseline Pressure Ratio = R4** | **RANC #1 Pressure Ratio = R5** | **RANC #2 Pressure Ratio = R6** | **Linear Nozzle RANC#1 Pressure Ratio = R8** |
|---|---|---|---|---|
| **9** | F2 (9.9) | --- | H2(16.39) | --- |
| **12** | F3(10.5) | G3(13.6) | H3(20.0) | 13(27.6) |
| **15** | F4(13.0) | G4(15.0) | H4(23.0) | --- |

**Table 10 - DVD NLOS version 2 process conditions with gas heater.**

| **Chamber Pressure Ar (Pa)** | **Baseline Pressure Ratio = R5** | **RANC #1 Pressure Ratio = R6** | **RANC #2 Pressure Ratio = R7** | **Linear Nozzle Pressure Ratio = R7** |
|---|---|---|---|---|
| **9** | F2 (12.5) | --- | H2(22.5) | --- |
| **12** | F3(11.28) | G3(14.6) | H3(26.1) | 13(11.0)* |
| **15** | F4(11.62) | G4(17.86) | H4(29.6) | --- |

A mock up box run was also performed using the linear nozzle configuration to determine LOS to NLOS thickness ratio for this set-up. For condition I3 the pressure ratio as high as 27.6 could be achieved. Mock-up box runs were performed using the linear nozzles. The results indicated that using this nozzle design with a moderate pressure ratio (11.0) and chamber pressure (process condition 13) resulted in good NLOS coating efficiency, Table 11. Note that the A to C ratio was as good as with the linear nozzle conditions and thus, this nozzle geometry appears to be well suited for scale the crucible / nozzle apparatus to full production scale dimensions.

**Table 11- Mock-up box results using linear, converging-diverging nozzle designs**

| **Process Condition** | **A to C** | **B to C** | **A to B** | **Average** |
|---|---|---|---|---|
| I3-M-P* | 1.2 | 1.15 | 1.04 | 1.13 |
| J3-M | 1.46 | 1.43 | 1.01 | 1.3 |

The above data is summarized in Figures 30. Figure 30 compares the best processing conditions using the DVD version 2.0 conditions (F3, C1, E2), with prior art conditions (B1). Note the significant improvement achieved compared with the "no gas" EB-PVD like conditions for the DVD version 2.0 conditions (F3, C1, E2). Also of significance is the ability to use the linear nozzle (condition I) to obtain suitable NLOS coating efficiency. Nozzles of this type are scalable for the use of large diameter crucibles without requiring significantly higher pumping rates, making them an important development in the economical application of NLOS coatings onto gas turbine engine components.

DVD Processing conditions appropriate for applying TBC layer onto NLOS regions Have been determined to be: Temp.= 950 to 1050°C, Pressure = 8 to 15 Pa, Pressure ratio = > 7, Carrier gas temperature: > 200°C, plasma activation can optionally be used.

In one embodiment, plasma-activation in DVD is performed by a hollow-cathode plasma unit capable of producing a high-density plasma in the system's gas and vapor stream. The particular hollow cathode arc plasma technology used in DVD is able to ionize a large percentage of all gas and vapor species in the mixed stream flowing towards the coating surface. This ionization percentage in a low vacuum environment is unique to the DVD system and importantly the use of the plasma generates ions that can be accelerated towards the coating surface by either a self-bias or by an applied electrical potential. This enables some vapor species, which would otherwise not deposit onto the NLOS surface the ability to deposit, thereby increasing the NLOS growth rate.

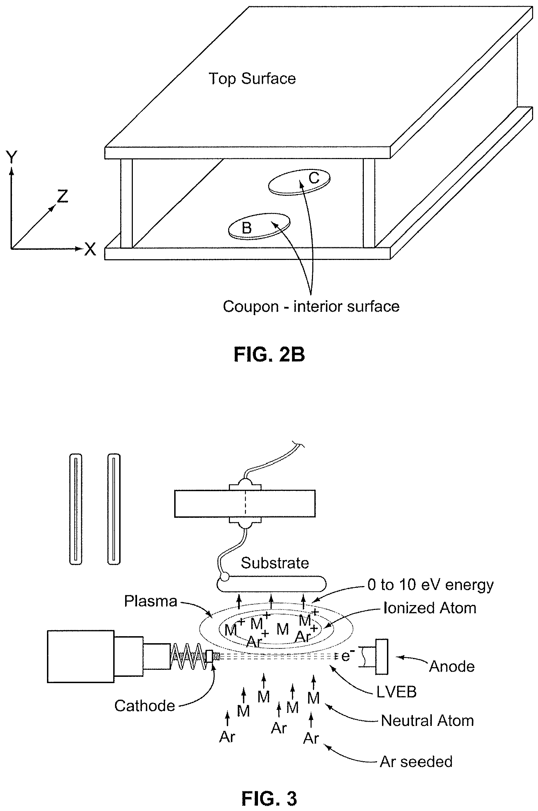

To demonstrate this effect, Fig. 2a and 2b illustrate a mock-up box having geometry representing a component having line of sight and NLOS sight regions. Fig. 2a illustrates coupon A with exterior surface and Fig. 2b illustrates interior surfaces in NLOS. A coating run was performed using the DVD plasma conditions and an inert gas, in this embodiment using for example He gas, and no carrier gas conditions to determine if enhanced NLOS growth rates could be obtained by ionizing vapor atoms and attracting them to the substrate using a substrate bias. The plasma conditions for these runs are given in Table 1. The coating data resulting from the runs are also given in Table 1.

**Table 1(I) - DVD Process Conditions used during the mock-up box coating of using the "A1 + plasma" deposition condition.**

| *I) Plasma Activation Process conditions for the "A1* + *Plasma" condition* | |
|---|---|
| **Plasma Current** | 60 A |
| **Bias Voltage (AC)** | +/- 200V |
| **Bias Voltage ½ Period** | +/- 24 microseconds / - 8 µs and +100 µs |
| **Bias Current (on substrate)** | 1.25 to 1.44 A |

**Table 1(II) DVD Process Conditions and Resulting Coupon Weight Gains for the "A1 + Plasma" condition for coating of YSZ layer.**

| **Condition** | **DVD plasma** | **No gas** |
|---|---|---|
| **Rotation/rpm** | 3 | 3 |
| **Δ*t*/min** | 35 | 42 |
| **YSZ fed in mm** | 83.96 | 42.32 |
| **YSZ** | 24.697 | |
| **Ni strip** | 0.1323 | |
| **Outside, A** | 0.1232 | 0.0597 |
| **inside, center, C** | 0.0263 | 0.0107 |
| **inside, end, B** | 0.0457 | 0.0185 |
| **A to C ratio** | 4.68 | 5.57 |
| **A to B ratio** | 2.67 | 3.22 |
| **B to C ratio** | 1.73 | 1.72 |
| | | |
| PWC/mbar | 0.19 | 3.8E-4 |
| PGFS/mbar | 1.1 | |
| PGFS / PWC | 5.8 | |
| *T*ₘₐₓ/°C | ∼900 | 900 |

The experimental set-up for the laboratory scale DVD system (LS-DVD) required modifications to the heating set-up to enable the deposition onto the mock-up box while using the plasma activation system, as illustrated in Figure 3. This embodiment included altering the AC bias period such that a negative bias was used to 8 microseconds and a positive bias for 100 microseconds so that the period of time for vapor atom attraction was as long to possible without building excessive charge on the substrate.

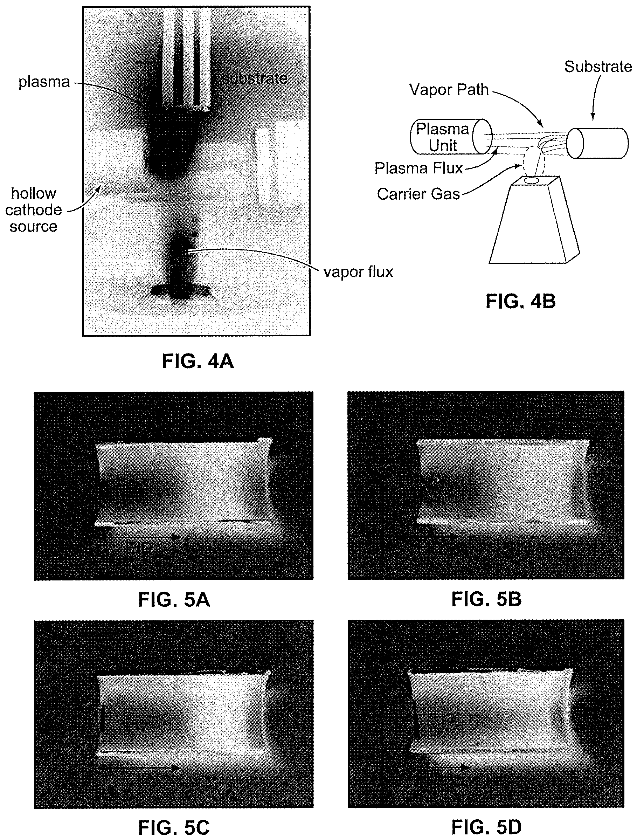

Results indicated that improved NLOS coating into the mock-up box was obtained including in this embodiment the usage of He gas as the carrier gas. Improvements were also noted through the addition of plasma activation and AC substrate biasing. Additional embodiments allow for the design of the plasma system and its introduction into the DVD processing environment in such a way that the plasma orientation may be aligned with the orientation of the vapor flux. The use of a heavier, Ar, carrier gas is also envisioned. This carrier gas can more effectively align the plasma direction with the direction of the vapor flux, such as illustrated in Figure 4. It is noted that the present disclosure includes the embodiments of Helium and Argon as exemplary inert gases, but other embodiments may utilize any other suitable inert gas and the present disclosure is not expressly limited to Helium and Argon.

A modified experimental set-up was also used to test the ability of the plasma system to further enhance NLOS coating efficiency. In this case, a 1" diameter tube substrate was used and aligned in two configurations: A) the tube was aligned at 90° with respect to a source and B) the tube was aligned parallel and above the source, such as visible in Figs. 4a and 4b. In A) the vapor flux was carried into the NLOS of the tube by an Ar carrier gas. In B) the electrons from the plasma flux were used to turn the vapor flux and direct it into the tube. The coating thickness distribution was measured with the goal of determining if an arrangement in which the plasma flux was in-line with the NLOS opening would enhance NLOS coating efficiency over baseline conditions. The plasma processing conditions (i.e. the plasma current, bias voltage) were set as given in Table 1l(III). A Ni-Cr-Fe alloy was used as the source material for these experiments to simplify the experimental operation.

**Table 1(III) - PA-DVD processing conditions for NLOS topcoat deposition**

| **Run Code** | **Substrate** | **Substrate Config.** | **Plasma** | **Gas Type** | **Time (min. )** | **Pressure Ratio** |
|---|---|---|---|---|---|---|
| NNS-121 | Stainless Steel Tube; Diameter: 1"; Length: 2" | B | -200V/ 60A | He(4slm) | 45 | 8.2 |
| NNS-122 | Stainless Steel Tube; Diameter: 1"; Length: 2" | B | -200V/ 60A | He(5slm) | 45 | 7.8 |
| NNS-123 | Stainless Steel Tube; Diameter: 1"; Length: 2" | B | -200V/ 60A | Ar(2slm) | 45 | 7.8 |
| NNS-124 | Stainless Steel Tube; Diameter: 1"; Length: 2" | **A** | -200V/ 60A | He(5slm) | 25 | 9.5 |

The results of Figures 5a-5d indicate that the Estimated Infiltration Distance (EID) for the coating was a function of process conditions. Figs. 5a-5d illustrate the corresponding stainless steel tube deposition results for NNS-121 (Fig. 5a), NNS-122 (Fig. 5b), NNS-123 (Fig. 5c) and NNS-124 (Fig. 5d), consistent with the Table 1(III). The largest EID's were obtained for the case of NNS-123 (plasma infiltration in Ar environment) and NNS-124 (carrier gas jet induced infiltration).

Two key results were obtained from these results: i) a plasma flux can be used to direct a vapor flux and promote its infiltration into NLOS regions; and ii) the plasma flux is estimated to be as effective as carrier gas jet for promoting the infiltration of a vapor flux into NLOS regions.

Thus, it appears that a plasma consisting in part of electrons having a scattering cross-sections may be an effective means to further promote additional NLOS coating efficiency. Thus, the combination of plasma infiltration with carrier gas infiltration will be an excellent technique to promote further NLOS coating capability

Microstructural analysis of the coated coupons of Fig. 2b was performed on coupons located in the NLOS region (i.e. coupon C) when using the above-described NLOS processing condition. Figs. 19a and 19b shows the SEM micrographs of the coating microstructure for TBC coating. It was clearly evident that the required columnar microstructure is obtained in the NLOS for this processing condition. The observed microstructure was very similar to the microstructure obtained for the case of coupon placed in line of sight (LOS) region of mock up box.

Thermal Spallation Resistance: Optimized DVD NLOS processing conditions determined above must demonstrate as good or better thermal spallation resistance compared with conventionally applied TBC coatings with no gas (baseline condition). Under a parallel effort (DOD contract number: W911QX-07-C-0013) testing has demonstrated that robust coatings can be produced using the PS-DVD coater and processing conditions which use DVD NLOS Version 2.0, Table 6. Additional optimization and testing will be continued using the most optimal Ar gas pressure for NLOS coating and the use of gas pre-heating.

**Table 6 - Thermal spallation resistance of DVD deposited TBC coatings using DVD NLOS**

| ***Sample*** | ***Current number of cycles*** |
|---|---|
| *DVD: Ar - 10 Pa* | *1121* |
| *DVD: Ar - 10 Pa* | *879* |
| *DVD: Ar - 10 Pa* | *879* |
| *DVD: Ar - 10 Pa* | *1118* |
| *EB-PVD Baseline* | *743* |

Erosion Testing (LOS and NLOS regions): TBC coated coupons placed in LOS and NLOS configurations. Low temperature erosion testing was then performed to demonstrate that as good or better erosion resistance than conventional EB-PVD TBC coatings can be obtained using the optimized DVD NLOS coating conditions.

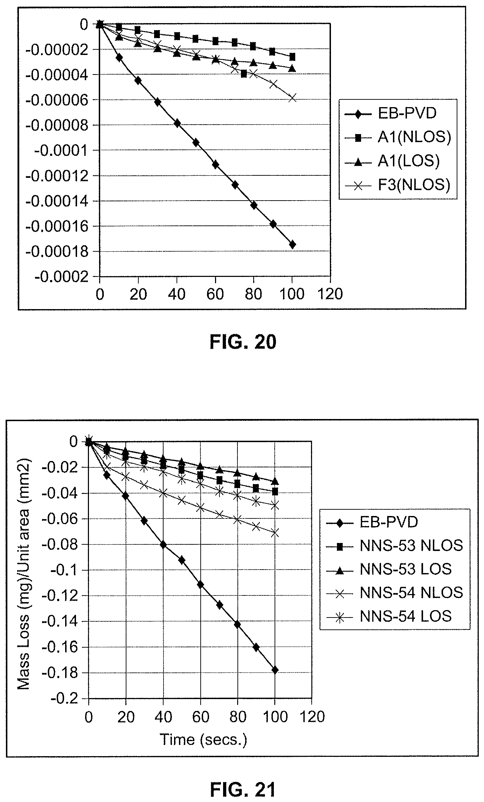

Room temperature erosion tests were performed on coupons created using the DVD NLOS F3-M condition. Figure 20, indicates that both the DVD NLOS F3 condition and the DVD NLOS version P1 condition resulted in improved erosion resistance over LOS EB-PVD conditions (No gas condition). Figure 21 summarizes the erosion resistance of two additional coatings (deposited under DVD NLOS F3-M, Table 7) in which both the LOS and NLOS regions were eroded as a function of time. It is evident that under the DVD NLOS F3-M process conditions the erosion resistance in NLOS regions is very good and in the same range as the TBC coating applied onto the LOS region. The good NLOS erosion resistance is believed to be due to the microstructure of NLOS being very similar to the LOS regions.

**Table 7 Summary of DVD NLOS conditions for sample NNS-53 & 54**

| **Sample #** | **Gas/Chamber Pressure** | **Gas Preheating** | **Process Condition** |
|---|---|---|---|
| NNS-53 | Ar-12 Pa | no | F3-M |
| NNS-54 | Ar-12 Pa | no | F3-M |

Notably, the figures and examples above are not meant to limit the scope of the present invention to a single embodiment, as other embodiments are possible by way of interchange of some or all of the described or illustrated elements. Moreover, where certain elements of the present invention can be partially or fully implemented using known components, only those portions of such known components that are necessary for an understanding of the present invention are described, and detailed descriptions of other portions of such known components are omitted so as not to obscure the invention. In the present specification, an embodiment showing a singular component should not necessarily be limited to other embodiments including a plurality of the same component, and vice-versa, unless explicitly stated otherwise herein. Moreover, Applicant does not intend for any term in the specification or claims to be ascribed an uncommon or special meaning unless explicitly set forth as such. Further, the present invention encompasses present and future known equivalents to the known components referred to herein by way of illustration.

The foregoing description of the specific embodiments so fully reveals the general nature of the invention that others can, by applying knowledge within the skill of the relevant art(s) (including the contents of the documents cited), readily modify and/or adapt for various applications such specific embodiments, without undue experimentation, without departing from the general concept of the present invention. Such adaptations and modifications are therefore intended to be within the meaning and range of equivalents of the invention, based on the teaching and guidance presented herein.

## Claims

1. A method for directed vapor deposition using a deposition chamber, the method comprising:
- evaporating a first material for deposition on a substrate, the evaporating generating a plurality of vapor molecules;
- using plasma activation, ionizing the plurality of vapor molecules to create charged vapor molecules;
- biasing the substrate using an electrical charge;
- via a converging-diverging nozzle comprising adjustable side nozzle plates having slots allowing the nozzle to be adjusted in a first direction (Y Direction), inserting an inert gas as a carrier gas into the deposition chamber concurrent with the ionizing the plurality of vapor molecules, the converging-diverging nozzle formed around an array of evaporation sources, which results in a rectangular or ellipsoidal shaped vapor flux with a controllable width in the first direction (Y direction) and a uniform density in a second direction (X direction), which is perpendicular to the first direction (Y direction); and
- aligning the charged vapor molecules using a plurality of inert gas characteristics such that the charged vapor molecules are directed for deposition on at least one non-line of sight portions of the substrate,
wherein the biasing comprises
- biasing the substrate with a negative bias for a first period of time; and
- biasing the substrate with a positive bias for a second period of time.

2. The method of claim 1, wherein the plasma activation is performed using a hollow-cathode plasma unit.

3. The method of one of the preceding claims, wherein the inert gas characteristics includes at least one of: a gas density; a gas pressure and a gas velocity; and
wherein, optionally, the inert gas includes at least one of: helium, argon, air, nitrogen, and oxygen.

4. The method of claim 3, wherein the method
further comprises heating the carrier gas prior to insertion in the deposition chamber.

5. The method of claim 4, wherein heating the carrier gas prior to insertion into the deposition chamber includes creating a supersonic gas jet providing vapor deposition in the non-line of sight portion of the substrate.

6. The method of one of the claims 4 or 5, wherein the heating of the carrier gas comprises:
- winding a gas delivery tube as a coil;
- applying a voltage to a first end and second end of the tube such that the tube becomes a resistive heater; and/or
wherein the method further comprises:
- maintaining a reactive gas mix separate from the carrier gas prior to heating the carrier gas; and
- combining the carrier gas with the reactive gas after the carrier gas has been heated; and/or
wherein the carrier gas is an inert gas such that the method comprises:
- heating the inert gas as the carrier gas for insertion in the deposition chamber; and
wherein, optionally, the inert gas includes at least one of: helium, argon, air, and nitrogen.

7. The method of claim 4, further comprising:
- focusing the rectangular or ellipsoidal shaped vapor flux of the vapor molecules to create a high density flux of vapor molecules;
- infiltrating the focused rectangular or ellipsoidal shaped vapor flux into an interior portion of the substrate; and
- defocusing the rectangular or ellipsoidal shaped vapor flux for deposition of the vapor molecules onto the non-line of sight portion of the substrate.

8. The method of claim 7, wherein the inert gas includes at least one of: helium, argon, air, nitrogen, and oxygen; and/or
wherein the inert gas characteristics includes at least one of: a gas density; a gas pressure and a gas velocity; and
wherein, optionally, the method further comprises:
- inserting the inert gas using a nozzle including adjusting the properties of the inert gas based on an opening of the nozzle.

9. The method of claim 1, wherein the carrier gas is preheated to a temperature in the range of 300 to 400 degrees Celsius prior to insertion in the deposition chamber.

10. An apparatus for directed vapor deposition on a substrate disposed in a deposition chamber, the apparatus comprising:
- at least one evaporant source disposed within the chamber;
- at least one carrier gas stream;
- a heating device for heating the carrier gas stream prior to entering the chamber such that a heated carrier gas stream is disposed into the chamber; and
- a vapor generation device operative to generate a plurality of vapor molecules from the evaporant source, such that, via a converging-diverging nozzle comprising adjustable side nozzle plates having slots allowing the nozzle to be adjusted in a first direction (Y direction), the heated carrier gas stream directs the vapor molecules for deposition on a non-line of sight portion of the substrate, the converging-diverging nozzle formed around the at least one evaporant source, which results in a rectangular or ellipsoidal shaped vapor flux with a controllable width in the first direction (Y direction) and a uniform density in a second direction (X direction), which is perpendicular to the first direction (Y direction),
- a plasma activation device operative to ionize the plurality of vapor molecules of the evaporant to create charged vapor molecules; and
- a biasing device operative to bias the substrate with a negative bias for a first period of time and with a positive bias for a second period of time, for attracting the charged vapor molecules onto the non-line of sight portion of the substrate.

11. The apparatus of claim 10, wherein the heating device comprises:
- a wound coil having the carrier gas pass there though; and
- a power source having connection elements for passing a voltage across the wound coil such that the coil becomes a resistive heater, thereby heating the carrier gas passing therethrough.

12. The apparatus of one of claims 10 or 11, wherein the apparatus is configured to introduce the inert gas, which includes at least one of: helium, argon, air, nitrogen, and oxygen; and/or wherein, optionally, the plasma activation device is a hollow cathode plasma unit.

13. The apparatus of claim 10, wherein the converging-diverging nozzle comprises an adjustable nozzle top plate comprising slots to allow adjustability in the second direction (X direction).

14. The apparatus of claim 10, wherein the converging-diverging nozzle is linear shaped.

## Patentansprüche

1. Verfahren zur gerichteten Gasphasenabscheidung unter Verwendung einer Abscheidungskammer, wobei das Verfahren umfasst:
- Verdampfen eines ersten Materials zur Abscheidung auf einem Substrat, wobei das Verdampfen eine Mehrzahl von Dampfmolekülen erzeugt;
- Verwendung von Plasmaaktivierung, um die Mehrzahl von Dampfmolekülen zu ionisieren und geladene Dampfmoleküle zu erzeugen;
- unter Vorspannung setzen des Substrats unter Verwendung einer elektrischen Ladung;
- Einführen von Inertgas als ein Trägergas in die Abscheidungskammer gleichzeitig mit dem Ionisieren der Mehrzahl von Dampfmolekülen, über eine konvergierende-divergierende Düse, welche einstellbare Düsenseitenplatten mit Aussparungen umfasst, welche es der Düse ermöglichen, in einer ersten Richtung (Y Richtung) eingestellt zu werden, wobei die konvergierende-divergierende Düse um ein Array von Verdampfungsquellen herum gebildet ist, was in einem rechtwinkligen oder ellipsoid-förmigen Dampffluss mit einer kontrollierbaren Breite in der ersten Richtung (Y Richtung) und einer gleichmäßigen Dichte in einer zweiten Richtung (X Richtung), welche senkrecht zur ersten Richtung (Y Richtung) ist, resultiert; und
- Ausrichten der geladenen Dampfmoleküle unter Verwendung einer Mehrzahl von Inertgas-Eigenschaften, so dass die geladenen Dampfmoleküle für die Abscheidung auf mindestens einem Abschnitt des Substrats der nicht in gerade Linie liegt, gerichtet werden,
wobei das unter Vorspannung setzen umfasst:
- unter Vorspannung setzen des Substrats mit einer negativen Vorspannung für einen ersten Zeitraum; und
- unter Vorspannung setzen des Substrats mit einer positiven Vorspannung für einen zweiten Zeitraum.

2. Verfahren nach Anspruch 1, wobei die Plasmaaktivierung unter Verwendung einer Hohlkathodenplasmaeinheit durchgeführt wird.

3. Verfahren nach einem der vorherigen Ansprüche, wobei die Inertgas-Eigenschaften mindestens eine Gasdichte, einen Gasdruck oder eine Gasgeschwindigkeit umfassen; und wobei das Inertgas optional mindestens eines von Helium, Argon, Luft, Stickstoff und Sauerstoff umfasst.

4. Verfahren nach Anspruch 3, wobei das Verfahren des Weiteren das Erhitzen des Trägergases vor dem Einführen in die Abscheidungskammer umfasst.

5. Verfahren nach Anspruch 4, wobei das Erhitzen des Trägergases vor dem Einführen in die Abscheidungskammer das Erzeugen eines Ultraschall-Gasstrahls umfasst, welcher Dampfabscheidung in dem Abschnitt des Substrats, der nicht in der geraden Linie liegt, bereitstellt.

6. Verfahren nach einem der Ansprüche 4 oder 5, wobei das Erhitzen des Trägergases umfasst:
- Wickeln eines Gaszuführungsschlauchs in die Form einer Spule;
- Anwenden einer Spannung an ein erstes Ende und ein zweites Ende des Schlauchs, so dass der Schlauch ein Widerstandselement wird; und/oder
wobei das Verfahren des Weiteren umfasst:
- getrennt halten einer reaktiven Gasmischung von dem Trägergas vor dem Erhitzen des Trägergases; und
- Kombinieren des Trägergases mit dem reaktiven Gas nachdem das Trägergas erhitzt worden ist; und/oder
wobei das Trägergas ein Inertgas ist, so dass das Verfahren umfasst:
- Erhitzen des Inertgases als das Trägergas für das Einführen in die Abscheidungskammer; und
wobei, optional, das Inertgas mindestens eines von Helium, Argon, Luft und Stickstoff umfasst.

7. Verfahren nach Anspruch 4, des Weiteren umfassend:
- Fokussieren des rechtwinkligen oder ellipsoid-förmigen Dampfflusses der Dampfmoleküle, um einen Fluss mit einer hohen Dichte an Dampfmolekülen zu erzeugen;
- Einführen des fokussierten rechtwinkligen oder ellipsoid-förmigen Dampfflusses in einen inneren Abschnitt des Substrats; und
- Defokussieren des rechtwinkligen oder ellipsoid-förmigen Dampfflusses zur Abscheidung von Dampfmolekülen auf dem Abschnitt des Substrats, der nicht in gerade Linie liegt.

8. Verfahren nach Anspruch 7, wobei das Inertgas mindestens eines von Helium, Argon, Luft, Stickstoff und Sauerstoff umfasst; und/oder
wobei die Inertgas-Eigenschaften mindestens eine Gasdichte, einen Gasdruck oder eine Gasgeschwindigkeit umfassen; und
wobei das Verfahren optional des Weiteren umfasst:
- Einführen des Inertgases unter Verwendung einer Düse, umfassend Einstellen der Eigenschaften des Inertgases basierend auf einer Öffnung der Düse.

9. Verfahren nach Anspruch 1, wobei das Trägergas, vor dem Einführen in die Abscheidungskammer, auf eine Temperatur vorgeheizt wird, welche im Bereich von 300 bis 400 Grad Celsius liegt.

10. Vorrichtung zur gerichteten Gasphasenabscheidung auf ein Substrat, welches in einer Abscheidungskammer angeordnet ist, wobei die Vorrichtung umfasst:
- mindestens eine Verdampfungsquelle, welche in der Kammer angeordnet ist;
- mindestens einen Trägergasstrom;
- eine Heizvorrichtung zum Erhitzen des Trägergasstroms, bevor dieser in die Kammer eintritt, so dass ein erhitzter Trägergasstrom in die Kammer eingeführt ist; und
- eine Dampferzeugungsvorrichtung, welche dazu eingerichtet ist, eine Mehrzahl von Dampfmolekülen aus der Verdampfungsquelle zu erzeugen, so dass, über eine konvergierende-divergierende Düse, welche einstellbare Düsenseitenplatten mit Aussparungen umfasst, welche es der Düse ermöglichen, in einer ersten Richtung (Y Richtung) eingestellt zu werden, der erhitzte Trägergasstrom die Dampfmoleküle zur Abscheidung auf einem Abschnitt des Substrats, der nicht in gerade Linie liegt, richtet, wobei die konvergierende-divergierende Düse um die mindestens eine Verdampfungsquelle herum gebildet ist, was in einem rechtwinkligen oder ellipsoid-förmigen Dampffluss mit einer kontrollierbaren Breite in der ersten Richtung (Y Richtung) und einer gleichmäßigen Dichte in einer zweiten Richtung (X Richtung), welche senkrecht zur ersten Richtung (Y Richtung) ist, resultiert;
- eine Plasmaaktivierungsvorrichtung, um die Mehrzahl von Dampfmolekülen aus der Verdampfung zu ionisieren, um geladene Dampfmoleküle zu erzeugen; und
- eine Vorspannungsvorrichtung, die dazu eingerichtet ist, das Substrat für einen ersten Zeitraum mit einer negativen Vorspannung und für einen zweiten Zeitraum mit einer positiven Vorspannung vorzuspannen, um die geladenen Dampfmoleküle auf den Abschnitt des Substrats, der nicht in gerader Linie liegt, anzuziehen.

11. Vorrichtung nach Anspruch 10, wobei die Heizvorrichtung umfasst:
- eine gewundene Spule mit dem dadurch passierenden Trägergas; und
- eine Energiequelle mit Verbindungselementen, um eine Spannung entlang der gewundenen Spule anzulegen, so dass die Spule ein Widerstandsheizelement wird, wodurch das dadurch passierende Trägergas erhitzt wird.

12. Vorrichtung nach einem der Ansprüche 10 oder 11, wobei die Vorrichtung dazu eingerichtet ist, das Inertgas einzuführen, welches mindestens eines von Helium, Argon, Luft, Stickstoff und Sauerstoff umfasst, und/oder wobei die Plasmaaktivierungsvorrichtung optional eine Hohlkathodenplasmaeinheit ist.

13. Vorrichtung nach Anspruch 10, wobei die konvergierende-divergierende Düse eine einstellbare Düsenoberplatte umfasst, welche Aussparungen umfasst, um eine Einstellbarkeit in der zweiten Richtung (X Richtung) zu ermöglichen.

14. Vorrichtung nach Anspruch 10, wobei die konvergierende-divergierende Düse linear gebildet ist.

## Revendications

1. Procédé de dépôt en phase vapeur dirigé utilisant une chambre de dépôt, le procédé comprenant :
- l'évaporation d'un premier matériau pour dépôt sur un substrat, l'évaporation générant une pluralité de molécules de vapeur ;
- l'utilisation d'une activation par plasma, ionisant la pluralité de molécules de vapeur pour créer des molécules de vapeur chargées ;
- la polarisation du substrat à l'aide d'une charge électrique ;
- via une buse convergente-divergente comprenant des plaques de buse latérales réglables ayant des fentes permettant d'ajuster la buse dans une première direction (direction Y), l'insertion d'un gaz inerte comme gaz porteur dans la chambre de dépôt en même temps que l'ionisation de la pluralité de molécules de vapeur, la buse convergente-divergente étant formée autour d'un réseau de sources d'évaporation, ce qui se traduit par un flux de vapeur de forme rectangulaire ou ellipsoïdale avec une largeur réglable dans la première direction (direction Y) et une densité uniforme dans une seconde direction (direction X), qui est perpendiculaire à la première direction (direction Y) ; et
- l'alignement des molécules de vapeur chargées à l'aide d'une pluralité de caractéristiques de gaz inerte de sorte que les molécules de vapeur chargées sont dirigées pour le dépôt sur au moins une partie hors de vue du substrat,
dans lequel la polarisation comprend
- la polarisation du substrat avec une polarisation négative pendant une première période de temps ; et
- la polarisation du substrat avec une polarisation positive pendant une seconde période de temps.

2. Procédé selon la revendication 1, dans lequel l'activation par plasma est effectuée à l'aide d'une unité à plasma à cathode creuse.

3. Procédé selon l'une des revendications précédentes, dans lequel les caractéristiques du gaz inerte comprennent au moins une caractéristique parmi : une densité de gaz ; une pression de gaz et une vitesse de gaz ; et
dans lequel, éventuellement, le gaz inerte comprend au moins un gaz parmi : l'hélium, l'argon, l'air, l'azote et l'oxygène.

4. Procédé selon la revendication 3, dans lequel le procédé comprend en outre le chauffage du gaz porteur avant l'insertion dans la chambre de dépôt.

5. Procédé selon la revendication 4, dans lequel le chauffage du gaz porteur avant l'insertion dans la chambre de dépôt comprend la création d'un jet de gaz supersonique assurant un dépôt en phase vapeur dans la partie hors de vue du substrat.

6. Procédé selon l'une des revendications 4 ou 5, dans lequel le chauffage du gaz vecteur comprend :
- l'enroulement d'un tube de distribution de gaz sous la forme d'une bobine ;
- l'application d'une tension à une première extrémité et à une seconde extrémité du tube de telle sorte que le tube devienne un élément chauffant résistif ; et/ou
dans lequel le procédé comprend en outre :
- le maintien d'un mélange de gaz réactif séparé du gaz porteur avant de chauffer le gaz porteur ; et
- la combinaison du gaz porteur avec le gaz réactif après que le gaz porteur ait été chauffé ; et/ou
dans lequel le gaz porteur est un gaz inerte de sorte que le procédé comprend :
- le chauffage du gaz inerte comme gaz porteur pour insertion dans la chambre de dépôt ; et
dans lequel, éventuellement, le gaz inerte comprend au moins un gaz parmi : l'hélium, l'argon, l'air et l'azote.

7. Procédé selon la revendication 4, comprenant en outre :
- la focalisation du flux de vapeur de forme rectangulaire ou ellipsoïdale des molécules de vapeur pour créer un flux de haute densité de molécules de vapeur ;
- l'infiltration du flux de vapeur concentré de forme rectangulaire ou ellipsoïdale dans une partie intérieure du substrat ; et
- la défocalisation du flux de vapeur de forme rectangulaire ou ellipsoïdale pour le dépôt des molécules de vapeur sur la partie hors de vue du substrat.

8. Procédé selon la revendication 7, dans lequel le gaz inerte comprend au moins un gaz parmi : l'hélium, l'argon, l'air, l'azote et l'oxygène ; et/ou
dans lequel les caractéristiques du gaz inerte comprennent au moins une caractéristique parmi : une densité de gaz ; une pression de gaz et une vitesse de gaz ; et
dans lequel, éventuellement, le procédé comprend en outre :
- l'insertion du gaz inerte à l'aide d'une buse comprenant l'ajustement des propriétés du gaz inerte sur la base d'une ouverture de la buse.

9. Procédé selon la revendication 1, dans lequel le gaz porteur est préchauffé à une température dans la plage de 300 à 400 degrés Celsius avant l'insertion dans la chambre de dépôt.

10. Appareil de dépôt en phase vapeur dirigé sur un substrat disposé dans une chambre de dépôt, l'appareil comprenant :
- au moins une source d'évaporant disposée à l'intérieur de la chambre ;
- au moins un courant de gaz porteur ;
- un dispositif de chauffage pour chauffer le courant de gaz porteur avant d'entrer dans la chambre de telle sorte qu'un courant de gaz porteur chauffé est disposé dans la chambre ; et
- un dispositif de génération de vapeur fonctionnant pour générer une pluralité de molécules de vapeur à partir de la source d'évaporant, de telle sorte que, via une buse convergente-divergente comprenant des plaques de buse latérales réglables ayant des fentes permettant à la buse d'être ajustée dans une première direction (direction Y), le courant de gaz porteur chauffé dirige les molécules de vapeur pour le dépôt sur une partie hors de vue du substrat, la buse convergente-divergente étant formée autour de l'au moins une source d'évaporant, ce qui se traduit par un flux de vapeur de forme rectangulaire ou ellipsoïdale avec une largeur réglable dans la première direction (direction Y) et une densité uniforme dans une seconde direction (direction X), qui est perpendiculaire à la première direction (direction Y),
- un dispositif d'activation par plasma fonctionnant pour ioniser la pluralité de molécules de vapeur de l'évaporant pour créer des molécules de vapeur chargées ; et
- un dispositif de polarisation fonctionnant pour polariser le substrat avec une polarisation négative pendant une première période de temps et avec une polarisation positive pendant une seconde période de temps, afin d'attirer les molécules de vapeur chargées sur la partie hors de vue du substrat.

11. Appareil selon la revendication 10, dans lequel le dispositif de chauffage comprend :
- une bobine enroulée dans laquelle passe le gaz porteur ; et
- une source d'alimentation ayant des éléments de connexion pour faire passer une tension à travers la bobine enroulée de telle sorte que la bobine devient un élément chauffant résistif, chauffant ainsi le gaz porteur qui la traverse.

12. Appareil selon l'une des revendications 10 ou 11, dans lequel l'appareil est conçu pour introduire le gaz inerte, qui comprend au moins un gaz parmi : l'hélium, l'argon, l'air, l'azote et l'oxygène ; et/ou dans lequel, éventuellement, le dispositif d'activation par plasma est une unité à plasma à cathode creuse.

13. Appareil selon la revendication 10, dans lequel la buse convergente-divergente comprend une plaque supérieure de buse réglable comprenant des fentes pour permettre un ajustement dans la seconde direction (direction X).

14. Appareil selon la revendication 10, dans lequel la buse convergente-divergente est de forme linéaire.
